# EUROPÄISCHE PATENTSCHRIFT

(11) **EP 1 803 963 B1**
(45) Veröffentlichungstag und Bekanntmachung des Hinweises auf die Patenterteilung: **26.08.2009**
(21) Anmeldenummer: 05028716.8
(22) Anmeldetag: 30.12.2005
(51) Int. Cl.: F16F 15/023, F16F 15/03, G03F 7/20

(54) **Hybrides Steifigkeitsmodul zur Schwingungsisolation**
Hybrid stiffness modul for vibration isolation
Modul hybride de rigidité pour islolation de vibrations

(43) Veröffentlichungstag der Anmeldung: 04.07.2007
(73) Patentinhaber: Integrated Dynamics Engineering GmbH, 65479 Raunheim (DE)
(72) Erfinder: Heiland, Peter, 65479 Raunheim (DE)
(74) Vertreter: Herden, Andreas F.

(56) Entgegenhaltungen:
- EP-A- 0 973 067
- BE-A- 476 448
- US-A1- 2003 148 853
- US-A1- 2004 080 729
- US-B1- 6 408 767

## Beschreibung

### Gebiet der Erfindung

Die Erfindung bezieht sich auf Schwingungsisolationssysteme und insbesondere auf ein Federsystem zur Schwingungsisolation.

### Hintergrund der Erfindung

Ein derartiges Schwingungsisolationssystem wird in EP 0 927 380 B1 = US 6,226,075 B1 (Erfinder: Erik R. Loopstra und Peter Heiland) offenbart und stellt ein vertikal und horizontal wirksames Luftlager dar. Solche Luftlager können abgedichtete Systeme sein, z.B. mittels eines Balgs, aber auch Systeme mit entweichender Luft. Derartige Luftlager weisen demnach einen hohen Luftverbrauch auf, insbesondere im Falle klein gebauter Luftlager und bei hohen Drucken und hohen spezifischen Traglastfähigkeiten. Ferner sind sie störempfindlich gegenüber Schwankungen des Versorgungsluftdrucks. Auch treten in solchen Luftlagersstemen nicht-laminare Luftströmungsverhältnisse auf, insbesondere bei hohem Druck, wobei aufgrund des damit verbundenen Strömungsabrisses Kraftrauschen in den Luftlagern auftritt, das als Eigenrauschen des Schwingungsisolators bemerkbar ist.

Luftfedersysteme ohne Luftverlust werden typischerweise mit Gummimembranen unterschiedlichster Formgebung abgedichtet.

Aus Sicht der Schwingungsisolation addieren derartige Gummimembranen eine "parasitäre" Steifigkeit, die in Verbindung mit der zu lagernden bzw. zu isolierenden Masse zu einer höheren Eigenfrequenz des Gesamtsystems führt. Diese höhere Eigenfrequenz isoliert gegenüber Schwingungen schlechter als eine niedrigere Eigenfrequenz. Aufgrund dieses Effektes kann beim Einsatz von Schwingungsisolatoren mit niedriger Eigenfrequenz für besonders kleine Schwingungsamplituden (< 1 µm) keine akzeptable Schwingungsisolation mehr erreicht werden, insbesondere wenn wegen seismischer Störungen Luftlagersysteme zur Schwingungsisolation verwendet werden.

Es gibt Bauformen mit integrierten vertikalen und horizontalen Luftlagerteilen (EP 0 927 380 B1), die zur vereinfachten und preisgünstigen Isolierung eingesetzt werden. Bei diesen Bauformen treten Verkopplungen der Kraft- und Bewegungsverhältnisse der beiden Lager auf. Diese Verkopplungen sind grundsätzlich unerwünscht, da sich dadurch die Steifigkeiten der Luftlager erhöhen, was zu einer Verschlechterung der schwingungsisolierenden Eigenschaften des Systems führt.

Weiterhin ist aus der EP 0 973 067 A ein Federsystem zur Schwingungsisolation bekannt, das ein horizontal wirkendes und ein vertikal wirkendes Luftlager sowie in z-Richtung wirkende magnetische Mittel aufweist. Bei diesem System ist das horizontal wirkende Luftlager oberhalb eines Kolbens angeordnet, der vertikal in einem Gehäuse geführt wird.

### Zusammenfassung der Erfindung

Der Erfindung liegt die Aufgabe zugrunde, bei einer vergleichsweise niedrigen Steifigkeit des Systems eine Erhöhung seiner spezifischen Traglastfähigkeit zu erreichen.

Die Erfindung wird in Anspruch 1 definiert.

Im einzelnen weist das Federsystem zur Schwingungsisolation, das ein vertikal und horizontal wirksames Luftlager darstellt, eine Basisplatte, ein Führungsgehäuse und einen Kolben mit darauf ruhender Last auf, wobei Luftdruck innerhalb des vom Kolben und dem Führungsgehäuse umschlossenen Raumes dafür sorgt, dass die Last auf einem gewissen Niveau gehalten wird. Gemäß einem ersten Aspekt der Erfindung sind magnetische Mittel vorgesehen, um die Traglastfähigkeit des Systems zu erhöhen. Zur Erhöhung der Traglastfähigkeit können auch mechanische Federn eingesetzt werden. Die Verwendung von magnetischen Mitteln hat den Vorteil, dass die Steifigkeit des Systems trotz Erhöhung der Traglastfähigkeit nicht erhöht wird.

Gemäß einem weiteren Aspekt der Erfindung können magnetische Mittel vorgesehen sein, die zwischen der Basisplatte und dem Führungsgehäuse wirksam sind, um den Lagerspalt zwischen diesen Teilen zu vergrößern und damit die Beweglichkeit des Luftlagers in horizontaler Richtung zu verbessern. Zu diesem Zweck können in der Basisplatte und dem Führungsgehäuse sich abstoßende Magnete eingebaut sein. Auch diese magnetischen Mittel führen nicht zu einer Erhöhung der Steifigkeit des Systems.

An der Basisplatte auftretende Schwingungen können vertikale und horizontale Komponenten aufweisen, die örtlich und zeitlich variieren. Um die Last möglichst von diesen Schwingungen zu isolieren, kann das vertikal und horizontal wirksame Luftlager ein unteres und ein oberes Drehgelenk aufweisen, so dass schiefe Stöße infolge der Bodenschwingungen, die auf das Luftlager einwirken, innerhalb des Luftlagers balanciert werden können, d.h. weniger zu Kippneigungen der Last führen.

Bei der Erfindung können tragende Luftlager und Magnetlager zur vertikalen und/oder horizontalen Schwingungsentkopplung kombiniert werden. Insbesondere wird die mögliche Tragfähigkeit des kombinierten Vertikal-Horizontal-Lagers bei gleichbleibendem Luftverbrauch verbessert. Ein derartiges kombiniertes Vertikal-Horizontal-Lager benötigt lediglich eine horizontale Bewegungsfreiheit von < 500 µm für Anwendungen bei typischen seismischen Bodenvibrationen.

Anstelle des Magnetlagers kann auch eine metallene Schraubenfeder mit dem vertikalen Luftlager kombiniert werden. Diese Schraubenfeder bietet zusätzliche Traglast bei gleichzeitiger inkrementaler Steifigkeit.

### Kurze Beschreibung der Zeichnungen

Ausführungsbeispiele der Erfindung werden anhand der Zeichnungen beschrieben.

Dabei zeigt:
- Fig. 1: im vertikalen Querschnitt eine schematische Ansicht eines ersten Ausführungsbeispiels des Federsystems
- Fig. 2: im vertikalen Querschnitt eine schematische Ansicht eines zweiten Ausführungsbeispiels des Federsystems
- Fig. 3: eine schematische Ansicht von oben des Federsystems nach Fig. 2
- Fig. 4: im vertikalen Querschnitt eine schematische Ansicht eines dritten Ausführungsbeispiels des Federsystems
- Fig. 5: im vertikalen Querschnitt eine schematische Ansicht eines vierten Ausführungsbeispiels des Federsystems

### Detaillierte Beschreibung

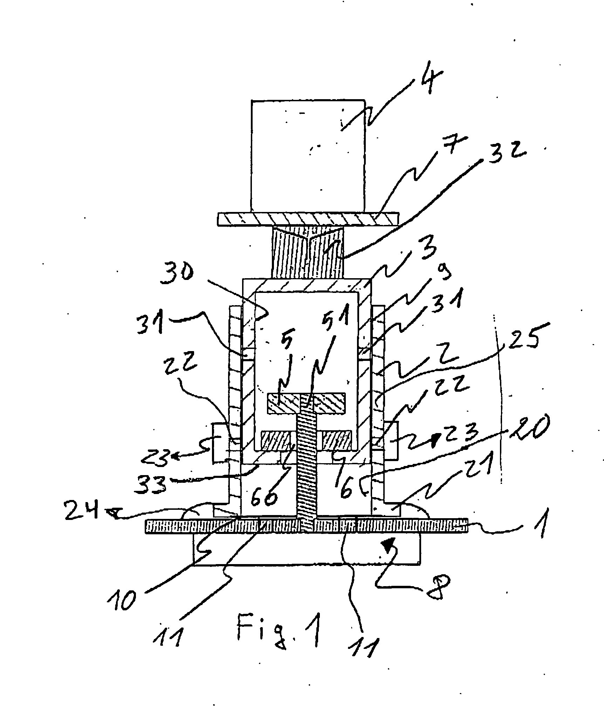

Ein hybrides Steifigkeitsmodul oder Luftlager-Federsystem gemäß einer ersten Ausführungsform der Erfindung ist in Fig. 1 dargestellt. Die Hauptbestandteile des Luftlager-Federsystems sind eine Bodenplatte 1, ein Führungsgehäuse 2, ein Kolben 3, eine Last 4, magnetische Mittel 5 und 6, eine Traglastplatte 7 und ein Luftzuführungssystem 8. Zwischen Kolben 3 und Führungsgehäuse 2 befindet sich ein Luftspalt 9 und zwischen Führungsgehäuse 2 und Basisplatte 1 ein Luftspalt 10.

Unterhalb der Bodenplatte 1 ist das Luftzuführungssystem 8 angebracht, welches dem Federsystem über mehrere Luftzuführungsöffnungen 11, die durch die Bodenplatte 1 geführt sind, Druckluft zuführt. Das Führungsgehäuse 2 umfasst einen Zylinder 25 und eine Aufstandsplatte 21, die auf der Bodenplatte 1 gleitet. Durch die Zylinderwände des Führungsgehäuses 2 sind mehrere Luftaustrittsöffnungen 22 gebohrt, an die sich Luftabführungseinrichtungen 23 anschließen.

Die Bodenplatte 1, das Führungsgehäuse 2 und der Kolben 3 schließen ein Luftvolumen 20 ein, dessen Größe auch von der Stellung des Kolbens 3 abhängt.

Infolge des Luftspalts 10 kann sich der Kolben 3 in vertikaler Richtung im Führungsgehäuse 2 bewegen. In der Seitenwand des Kolbens 3 sind mehrere Luftaustrittöffnungen 31 vorhanden, die in den zwischen Kolben 3 und Führungsgehäuse 2 befindlichen Luftspalt 9 führen. An der Oberseite des Kolbens 3 schließt sich ein Zwischenteil 32 an, auf dem sich die Traglastplatte 7 befindet. Auf die Traglastplatte 7 wird die zu stützende Last 4 gesetzt.

Die vom Luftzuführungssystem 8 in das Luftlager-Federsystem einströmende Luft trägt das Führungsgehäuse 2 über ein Luftpolster im Spalt 10 sowie den Innenraum 30 des Kolbens 3 und entweicht über die Luftaustrittsöffnungen 31 und 22 und die Spalten 9 und 10. Das Luftpolster im Spalt 10 ist typischerweise einige µm dick.

Kolben 3 und Führungsgehäuse 2 bilden ein vertikales Luftlager. Die gebildete Steifigkeit des Luft- bzw. Gaslagers entlang der vertikalen Wirkachse wird bestimmt durch die Größe des eingeschlossenen Luftvolumens 20, die effektive Wirkfläche 33 (bestimmt durch den äußeren Durchmesser des Kolbens 3), den Isentropenkoeffizient (= Adiabatenkoeefizient) des eingeschlossenen Gases und den beaufschlagten Innendruck im Luftvolumen.

Die Bedeutung der Steifigkeit des Luftlager-Federsystems besteht darin, dass im Falle einer hohen Steifigkeit von außen auf das System einwirkende Schwingungen in höherem Maße an die zu isolierende Last 4 weitergegeben werden, als dies bei einer niedrigen Steifigkeit geschieht.

Das aus Kolben 3 und Führungsgehäuse 2 gebildete vertikale Luftlager hätte für sich allein eine äußerst große Steifigkeit in horizontaler Richtung, d.h. "hohe horizontale Steifigkeit". Deshalb ist, zur Senkung dieser horizontalen Steifigkeit, zur Bildung des horizontalen Lagers der Luftspalt 10 vorgesehen. Infolge dieses Luftspaltes ist die horizontale Steifigkeit äußerst gering.

Die Last oder Masse für das erfindungsgemäße Schwingungsisolationssystem wird normalerweise durch ein Meßgerät oder eine Produktionseinrichtung wie ein lithographisches Gerät oder dergleichen gebildet. Diese sind typischerweise empfindlich gegenüber Bodenvibrationen sowohl in vertikaler als auch in horizontaler Richtung. Additiv zur vertikalen Luftfeder wird also das System mit hinreichend niedriger horizontaler Steifigkeit gebaut, um die zu isolierende Last vor der Einwirkung von Schwingungen, wie z.B. Bodenvibrationen, zu schützen. Dies gelingt durch das kombinierte vertikale und horizontale Luftlager, d.h. die Luftspalte 9 und 10.

Zur Senkung des Luftverbrauchs könnte man sich die Spalten 9 und 10 durch Gummimembranen abgedichtet denken. Im Gegensatz zur Verwendung von Gummimembranen hat die Ausführung der Konstruktion mit einem freien Luftspalt zur Folge, dass die aufgrund der Gummimembranen parallel zur vertikalen bzw. horizontalen Wirkachse entstehende Steifigkeit nicht auftritt. Daher kann mit einem freien Luftspalt eine Luft- bzw. Gasfeder mit minimaler Steifigkeit gebaut werden. Dabei muss man allerdings den permanenten Luftverlust über die Luftspalte 9 und 10 in Kauf nehmen.

Wie nachfolgend beschrieben, wird eine minimale Steifigkeit des Luftlager-Federsystems erzielt, wobei der permanente Luftverlust über die Luftspalte 9 und 10 durch die Erfindung reduziert wird, wie nachfolgend beschrieben.

Auf der Innenseite der Bodenfläche 33 des Kolbens 3 ist ein beispielsweise ringförmig ausgebildeter Magnet 6 angebracht. Durch eine Öffnung 60 dieses Magneten 6 führt von der Bodenplatte 1 eine Stange 51 in das Innere 30 des Kolbens 3. Die Stange 51 trägt an ihrem oberen Ende einen Magneten 5.

Sofern die Magnete 5 und 6 von anziehender Polarität sind, so entsteht hierdurch eine magnetische Kraft, die den Kolben 3 und damit die Last 4 anhebt. Diese magnetische Kraft wirkt also in die gleiche Richtung wie die aufgrund des statischen Druckes im Raum 20 entstehende Kraft. Insgesamt wird die Tragkraft des Systems erhöht, ohne dass gleichzeitig dessen Steifigkeit erhöht wird, denn der statische Druck bleibt konstant.

Als Kombination von magnetischen Mitteln 5 und 6 kann in einer weiteren Ausführungsform der Erfindung auch eine Kombination von aktiven Magneten (z.B. Elektromagneten) und passiven Weicheisenteilen angesehen werden. Hierbei stehen sich Magnete und Weicheisenteile gegenüber und ziehen sich an, so dass im Ergebnis wiederum eine positive und traglaststärkende Kraft entsteht.

Eine derartige Kombination aus Magneten und Weicheisenteilen kann entweder nur parallel zum horizontalen Luftlager, oder sowohl parallel zum horizontalen Luftlager als auch zum vertikalen Luftlager in das Federsystem eingebaut werden. Eine zu beiden Luftlagern parallel eingebaute Kombination aus Magneten und Weicheisenteilen bietet die Möglichkeit einer Minimierung des für beide Lager erforderlichen Drucks. Im Ergebnis wird der erforderliche Druckluftvolumenstrom klein gehalten.

Der Magnetanteil der Kombination aus Magneten und Weicheisenteilen kann sowohl von einem Permanent- als auch einem Elektromagneten gebildet werden.

Die Kombination aus Elektromagneten und Weicheisenteilen bietet einen weiteren Vorteil, da sich sowohl in vertikaler als auch in horizontaler Richtung eine gegenüber anderen Kombinationen verbesserte Linearität der Steifigkeit ergibt. Dies führt dazu, dass bei der Verwendung eines derart ausgebildeten Federsystems zusammen mit geregelter Magnetkraft keine Instabilität auftritt.

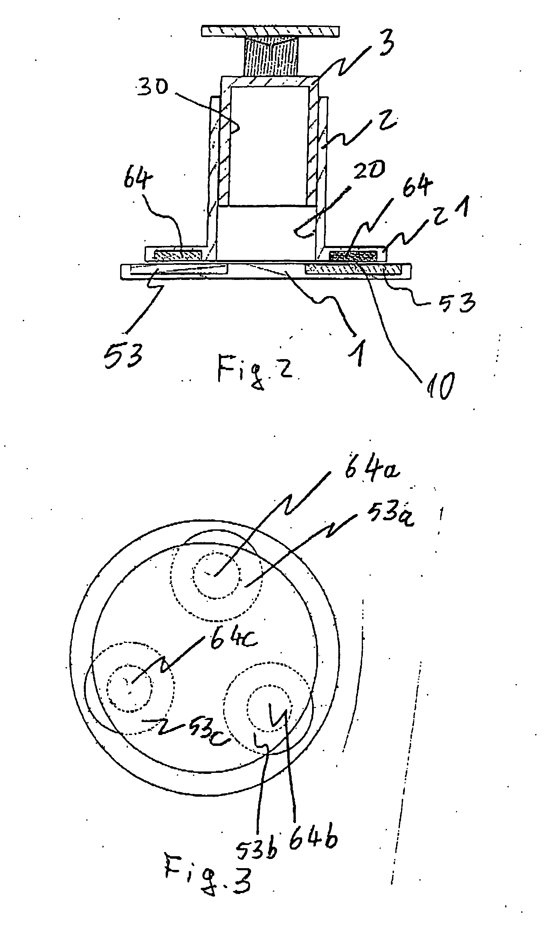

Fig. 2 entspricht der Ausführungsform der Fig. 1, jedoch wurden aus übersichtsgründen die Luftzu- und - abführungssysteme nicht eingezeichnet. Das Magnetsystem 5, 6 kann, muss aber nicht vorhanden sein.

Das in Fig. 2 dargestellte weitere Ausführungsbeispiel des Luftlager-Federsystems unterscheidet sich vom Ausführungsbeispiel aus Fig. 1 dadurch, dass sich einander abstoßende Magnete 53, 64 in die Bodenplatte 1 und die Aufstandsplatte 21 integriert werden. Diese Kombinationen können jeweils aus mindestens drei an der Oberseite der Bodenplatte 1 angebrachten Magneten 53a, 53b, 53c und drei an der Unterseite der Aufstandsplatte 21 angebrachten Magneten 64a, 64b, 64c bestehen. Die Magnete 53, 64 sind von abstoßender Polarität, so dass eine magnetische Kraft wirkt, die der aufgrund des einströmenden Luftstroms anhebenden Kraft gleichgerichtet ist. Dies führt bei ansonsten gleichen Bedingungen zu einer stärkeren Anhebung des Führungsgehäuses 2 und damit zu einem dickeren Luftpolster 10 zu einer Reduzierung der horizontalen Steifigkeit des Lagers.

Diese Kombinationen von Magneten sollen in einer rotationssymmetrischen Ausführung relativ zur Mittelachse von Führungsgehäuse 2 und Kolben 3 angeordnet sein. Die Ausführung der Magnete ist hierbei so zu wählen, dass nur minimale horizontale Kräfte und Steifigkeiten entstehen. Um dieses Ziel zu erreichen, kann die Geometrie der Magnete dergestalt optimiert sein, dass rotationssymmetrische Rundmagnete eingesetzt werden, die gleich groß sind. Dies ist möglich, da die geringe horizontale Bewegungsfreiheit seismischer Systeme in der Regel < 500 µm beträgt, bzw. nur erfordert, dass wenige 10 µm horizontale Relativbewegung auftreten.

Sofern das horizontale Luftlager von einer derartigen Geometrie ist, dass die sich gegenüber liegenden Flächen nicht parallel sind, müssten die Magnete 53, 64 dergestalt in die beiden Flächen integriert werden, dass nur jeder einzelne Magnet für sich allein jeweils plan in "seine" Fläche eingebaut wäre. Diese Anordnung würde allerdings kein planes Gegenüberliegen der beiden Magnete zulassen. Die hierbei zusätzlich auftretenden horizontalen Kräfte und Steifigkeiten würden aber durch den Einsatz von mindestens drei solcher Magnetkombinationen untereinander vektoriell kompensiert.

Da die Magnete dergestalt angeordnet sind, dass sich gleichnamige Pole gegenüber stehen, entstehen zwischen den Magneten abstoßende Kräfte und Steifigkeiten, die additiv zu der Kraft bzw. der Steifigkeit des Luftlagers wirken. Daher kann das Luftlager zum Erreichen einer bestimmten Tragkraft des gesamten Federsystems beim zusätzlichen Einsatz von Magnetlagern mit einem geringeren Druck beaufschlagt werden, als dies ohne die Verwendung der Magnetlager der Fall wäre. Es kann also bei einem geringeren Volumenstrom eine gleiche "Flughöhe" erreicht werden. Im Ergebnis sinken der Luftverbrauch und die damit verbundenen Kosten. Auch wird das mit Strömungsabrissen verbundene Lagerrauschen minimiert.

Fig. 3 zeigt eine für das in Fig. 2 dargestellte Ausführungsbeispiel der Erfindung typische Anordnung der dritten und vierten Magnete 53a, 53b, 53c, 64a, 64b, 64c. Hierbei sind drei Paare von drittem und viertem Magnet 53, 64 auf dem Umfang eines Kreises angeordnet. Jedes dieser drei Paare von drittem und viertem Magnet 53, 64 ist jeweils konzentrisch angeordnet.

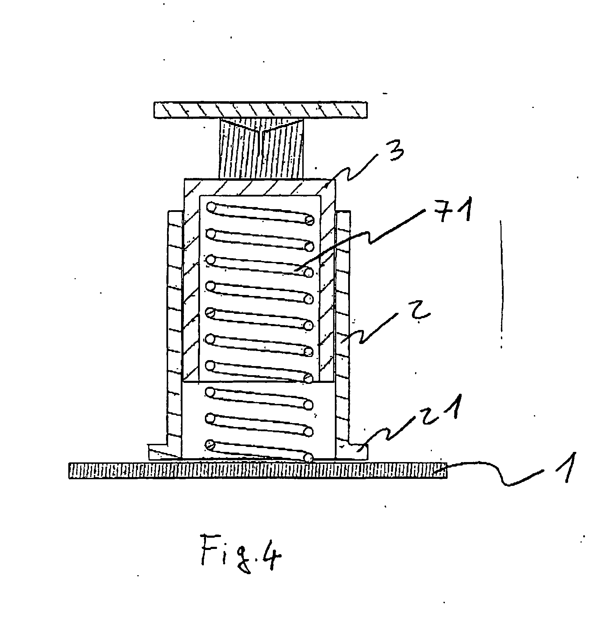

Ein weiteres Ausführungsbeispiel der Erfindung ist in Fig. 4 dargestellt, wobei die Luftzu- und -abführungssysteme aus Übersichtsgründen nicht eingezeichnet wurden. Bei diesem Ausführungsbeispiel der Erfindung sind die ersten und zweiten Magneten 5,6 mit der Stange 51 durch eine mechanische, metallene Schraubenfeder 71 ersetzt, die an ihrem unteren Ende an der Bodenplatte 1 und mit ihrem oberen Ende an der oberen Innenseite des Kolbens 3 befestigt ist.

Die Steifigkeit der Schraubenfeder 71 sollte zwischen 0 und 70 % der ultimativ erforderlichen Gesamtsteifigkeit des Schwingungsisolators in vertikaler und horizontaler Richtung ausmachen. Im Gegensatz zu der rein magnetischen Anordnung des vorangehend beschriebenen Ausführungsbeispiels der Erfindung ist die Verwendung der Schraubenfeder geeignet, sowohl das vertikale als auch das horizontale Luftlager hinsichtlich der zu tragenden Last zu unterstützen bzw. zu entlasten. Im Ergebnis wird auch bei dieser Ausführungsform der Erfindung der für beide Luftlager erforderliche Luftvolumenstrom klein gehalten, da die additiv wirkende Steifigkeit der Schraubenfeder ebenfalls das durch Strömungsabrisse verursachte Lagerrauschen minimiert.

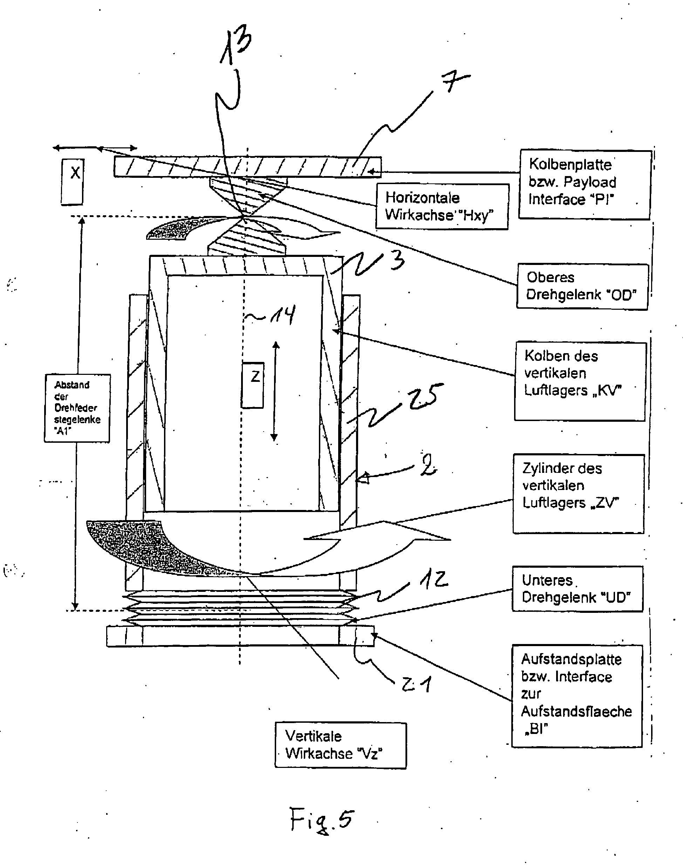

Fig. 5 zeigt ein rudimentäres Luftlager-Federystem, bei dem die Innereien der Ausführungsbeispiele Fig. 1 bis Fig. 4 hinzutreten. Zwischen Zylinder 25 und Aufstandsplatte 21 befindet sich ein unteres bewegliches Zwischenteil 12 und zwischen der oberen Außenfläche des Kolbens 3 und der Traglastplatte 7 ein oberes bewegliches Zwischenteil 13. Das untere bewegliche Zwischenteil 12 wird als ein Balg ausgeführt, der als Drehgelenk wirksam ist. Das obere Zwischenteil 13 kann ebenfalls als Drehgelenk ausgeführt werden, beispielsweise mit verdünntem, elastischem Wandteil, wie dargestellt, oder als Kugel-Drehgelenk.

In dieser Ausführungsform der Erfindung sind diese beiden Drehgelenke 12, 13 mit zusammenfallenden Drehachsen 14 zueinander angeordnet. Wirkt nun beispielsweise eine Bodenvibration, die sowohl vertikale als auch horizontale Schwingungskomponenten aufweist, auf das Luftlager-Federsystem in der Ausführungsform Fig. 5 ein, so ergibt sich im Ergebnis eine in "schiefer" Richtung auf das System einwirkende Kraft. Das obere und das untere Drehgelenk bewirken zusammen, dass sich die horizontale Ausrichtung der Last 4 trotz der "schief" wirkenden Kraft nicht ändert, beispielsweise also weiterhin parallel zum Boden ausgerichtet ist, wie es bei vielen Anwendungen eines Lagersystems erwünscht ist. Die Drehgelenke 12, 13 sind auch zur Kompensation von Drehschwingungen günstig, die auf das System einwirken.

## Patentansprüche

1. Federsystem zur Schwingungsisolation einer Last (4), umfassend:
eine Basisplatte;
ein darauf ruhendes Führungsgehäuse (2);
ein darin geführter Kolben (3),
ein horizontal wirksames Luftlager, gebildet durch die Basisplatte (1) und das darauf ruhende Führungsgehäuse (2) , zwischen denen ein Luftspalt (10) mit entweichender Luft besteht, so dass sich das Führungsgehäuse (2) auf der Basisplatte (1) bewegen kann;
und ein vertikal wirksames Luftlager, gebildet durch das Führungsgehäuse (2) und den darin geführten Kolben (3) zum Tragen, der Last (4), die gegenüber der Basisplatte (1) in horizontaler und vertikaler Richtung schwingungsisoliert gestützt werden soll, wobei ferner magnetische Mittel (5, 6) und/oder Federmittel (7) zwischen Basisplatte (1) und Kolben (3) wirksame sind, um eine zusätzliche Stütze für die Last (4) zu bilden.

2. Federsystem nach Anspruch 1,
**dadurch gekennzeichnet, dass** die magnetischen Mittel (5, 6) einen ersten an der Basisplatte (1) angebrachten Magneten (5) und einen zweiten an dem Kolben (3) angebrachten Magneten (6) umfassen.

3. Federsystem nach Anspruch 2,
**dadurch gekennzeichnet, dass** der erste Magnet (5) oberhalb des zweiten Magneten (6) angebracht ist, und die Magneten von anziehender Polarität sind.

4. Federsystem nach Anspruch 3,
**dadurch gekennzeichnet, dass** der erste Magnet (5) über eine Stange (51) mit der Basisplatte (1) verbunden ist, dass der zweite Magnet (6) ringförmig ausgebildet ist und dass die Stange (51) durch die Öffnung (60) des zweiten Magneten (6) hindurchreicht.

5. Federsystem nach Anspruch 1,
**dadurch gekennzeichnet, dass** die magnetischen Mittel (5, 6) aus einer Kombination von Magneten und Weicheisenteilen bestehen, und die Magnete den Weicheisenteilen gegenüberstehen und diese anziehen.

6. Federsystem nach Anspruch 5,
**dadurch gekennzeichnet, dass** die Magnete Permanentmagnete sind.

7. Federsystem nach Anspruch 5,
**dadurch gekennzeichnet, dass** die Magnete Elektromagnete sind.

8. Federsystem nach Anspruch 1,
**dadurch gekennzeichnet, dass** die Federmittel (7) wenigstens eine Schraubenfeder (71) umfassen.

9. Federsystem nach Anspruch 1,
**dadurch gekennzeichnet, dass** die magnetischen Mittel mindestens einen an der Basisplatte (1) angebrachten dritten Magneten (53) und mindestens einen an dem Führungsgehäuse (2) angebrachten vierten Magneten (64) aufweisen, die von abstoßender Polarität sind.

10. Federsystem nach Anspruch 9,
**dadurch gekennzeichnet, dass** die paarweise zueinander gehörigen dritten und vierten Magneten (53, 64) Einzelmagnete (53a, 53b, 53c; 64a, 64b, 64c) enthalten, die jeweils konzentrisch zueinander angeordnet sind.

11. Federsystem nach Anspruch 9,
**dadurch gekennzeichnet, dass** dritte und vierte Magnetpaare (53a, 64a; 53b, 64b; 53c, 64c) symmetrisch zum Federsystem angeordnet sind.

12. Federsystem nach einem der Ansprüche 1 bis 11,
**dadurch gekennzeichnet, dass** das Führungsgehäuse (2) eine Aufstandsplatte (21), einen Führungszylinder (25) und ein unteres als Drehgelenk wirksames Zwischenteil (12) umfasst.

13. Federsystem nach Anspruch 12,
**dadurch gekennzeichnet, dass** das untere bewegliche Zwischenteil (12) als ein Balg ausgeführt ist.

14. Federsystem nach einem der Ansprüche 1 bis 13,
**dadurch gekennzeichnet, dass** der Kolben (3) mit einer Traglastplatte (7) verbunden ist, auf der die Last (4) aufruht und
dass ein oberes Drehgelenk (13) zur Verbindung von Traglastplatte (7) und Kolben (3) vorgesehen ist.

15. Federsystem nach einem der Ansprüche 12 bis 14,
**dadurch gekennzeichnet, dass** obere und untere Drehgelenke (12, 13) mit zusammenfallenden Drehachsen (14) zueinander angeordnet sind.

## Claims

1. Spring system for the vibration isolation of a load (4), comprising:
a base plate;
a guide housing (2) resting thereon;
a piston (3) guided therein,
a horizontally effective air bearing which is formed by the base plate (1) and the guide housing (2) resting thereon, between which there is produced an air gap (10) having leaking air so that the guide housing (2) can move on the base plate (1); and
a vertically effective air bearing which is formed by the guide housing (2) and the piston (3) guided therein to bear the load (4) which is to be supported with respect to the base plate (1) in the horizontal and vertical direction in a vibration-isolated manner, wherein furthermore magnetic means (5, 6) and/or spring means (7) are effective between the base plate (1) and the piston (3) in order to form an additional support for the load (4).

2. Spring system as claimed in Claim 1, **characterised in that** the magnetic means (5, 6) include a first magnet (5) mounted on the base plate (1) and a second magnet (6) mounted on the piston (3).

3. Spring system as claimed in Claim 2, **characterised in that** the first magnet (5) is mounted above the second magnet (6) and the magnets are of opposite polarity.

4. Spring system as claimed in Claim 3, **characterised in that** the first magnet (5) is connected to the base plate (1) via a rod (51), **in that** the second magnet (6) is formed in an annular manner, and **in that** the rod (51) penetrates through the opening (60) in the second magnet (6).

5. Spring system as claimed in Claim 1, **characterised in that** the magnetic means (5, 6) consist of a combination of magnets and soft iron parts, and the magnets face and attract the soft iron parts.

6. Spring system as claimed in Claim 5, **characterised in that** the magnets are permanent magnets.

7. Spring system as claimed in Claim 5, **characterised in that** the magnets are electromagnets.

8. Spring system as claimed in Claim 1, **characterised in that** the spring means (7) include at least one helical spring (71).

9. Spring system as claimed in Claim 1, **characterised in that** the magnetic means comprise at least one third magnet (53) mounted on the base plate (1) and at least one fourth magnet (64) mounted on the guide housing (2) which are of the same polarity.

10. Spring system as claimed in Claim 9, **characterised in that** the mutually paired third and fourth magnets (53, 64) contain individual magnets (53a, 53b, 53c; 64a, 64b, 64c) which are disposed concentrically with respect to each other in each case.

11. Spring system as claimed in Claim 9, **characterised in that** third and fourth magnet pairs (53a, 64a; 53b, 64b; 53c, 64c) are disposed symmetrically with respect to the spring system.

12. Spring system as claimed in any one of Claims 1 to 11, **characterised in that** the guide housing (2) includes a contact plate (21), a guide cylinder (25) and a lower intermediate part (12) used as a pivot joint.

13. Spring system as claimed in Claim 12, **characterised in that** the lower movable intermediate part (12) is designed as bellows.

14. Spring system as claimed in any one of Claims 1 to 13, **characterised in that** the piston (3) is connected to a bearing load plate (7) on which the load (4) rests, and **in that** an upper pivot joint (13) is provided to connect the bearing load plate (7) and the piston (3).

15. Spring system as claimed in any one of Claims 12 to 14, **characterised in that** the upper and lower pivot joints (12, 13) are disposed with axes of rotation (14) which are co-incident with respect to each other.

## Revendications

1. Système de ressort pour l'isolation des vibrations d'une charge (4), comprenant une plaque de base, un boîtier de guidage (2) reposant dessus, un piston (3) guidé à l'intérieur, un palier d'air efficace horizontalement, formé par la plaque de base (1), et le boîtier de guidage (2) reposant dessus, entre lesquels existe une fente d'aération (10) avec de l'air qui s'échappe, de sorte que le boîtier de guidage (2) peut se déplacer sur la plaque de base (1), et un palier d'air efficace verticalement, formé par le boîtier de guidage (2) et le piston (3) guidé à l'intérieur pour porter la charge (4), qui doit être soutenue de façon isolée vis-à-vis des vibrations par rapport à la plaque de base (1) dans la direction horizontale et dans la direction verticale, des moyens (5, 6) magnétiques et/ou des moyens élastiques (7) étant également efficaces entre la plaque de base (1) et le piston (3), afin de former un soutien supplémentaire pour la charge (4).

2. Système de ressort selon la revendication 1,
**caractérisé en ce que** les moyens (5, 6) magnétiques comportent un premier aimant (5) placé sur la plaque de base (1) et un second aimant (6) placé sur le piston (3).

3. Système de ressort selon la revendication 2,
**caractérisé en ce que** le premier aimant (5) est placé au-dessus du second aimant (6), et les aimants sont de polarité attractive.

4. Système de ressort selon la revendication 3,
**caractérisé en ce que** le premier aimant (5) est relié par une barre (51) à la plaque de base (1), **en ce que** le second aimant (6) est conçu avec une forme annulaire et **en ce que** la barre (51) passe à travers l'ouverture (60) du second aimant (6).

5. Système de ressort selon la revendication 1,
**caractérisé en ce que** les moyens (5, 6) magnétiques sont constitués d'une combinaison d'aimants et de parties en fer doux, et les aimants sont opposés aux parties en fer doux et les attirent.

6. Système de ressort selon la revendication 5,
**caractérisé en ce que** les aimants sont des aimants permanents.

7. Système de ressort selon la revendication 5,
**caractérisé en ce que** les aimants sont des électroaimants.

8. Système de ressort selon la revendication 1,
**caractérisé en ce que** les moyens élastiques (7) comportent au moins un ressort hélicoïdal (71).

9. Système de ressort selon la revendication 1,
**caractérisé en ce que** les moyens magnétiques comportent au moins un troisième aimant (53) placé sur la plaque de base (1) et au moins un quatrième aimant (64) placé sur le boîtier de guidage (2), qui sont de polarité répulsive.

10. Système de ressort selon la revendication 9,
**caractérisé en ce que**
les troisièmes et quatrièmes aimants (53, 64), qui en font partie par paires, contiennent des aimants individuels (53a ; 53b, 53c ; 64a, 64b, 64c), qui sont disposés respectivement de façon concentrique les uns par rapport aux autres.

11. Système de ressort selon la revendication 9,
**caractérisé en ce que** les troisième et quatrième paires d'aimants (53a, 64a ; 53b, 64b ; 53c, 64c) sont disposés de façon symétrique par rapport au système de ressort.

12. Système de ressort selon l'une quelconque des revendications 1 à 11,
**caractérisé en ce que** le boîtier de guidage (2) comporte une plaque de contact (21), un cylindre de guidage (25) et une partie intermédiaire (12) inférieure efficace comme articulation rotative.

13. Système de ressort selon la revendication 12,
**caractérisé en ce que** la partie intermédiaire (12) inférieure et mobile est réalisée sous forme d'un soufflet.

14. Système de ressort selon l'une quelconque des revendications 1 à 13,
**caractérisé en ce que** le piston (3) est relié à une plaque de charge porteuse (7), sur laquelle la charge (4) repose et
**en ce qu'**une articulation rotative (13) supérieure est prévue pour la liaison de la plaque de charge porteuse (7) et du piston (3).

15. Système de ressort selon l'une quelconque des revendications 12 à 14,
**caractérisé en ce que** des articulations rotatives (12, 13) supérieures et inférieures sont disposées avec des axes de rotation (14) coïncidents les uns par rapport aux autres.
